# EUROPEAN PATENT APPLICATION

(11) **EP 2 639 835 A1**
(43) Date of publication of application: **18.09.2013**
(21) Application number: 11839097.0
(22) Date of filing: 18.10.2011
(51) Int. Cl.: H01L 31/042

(54) **SOLAR BATTERY MODULE AND MANUFACTURING METHOD THEREOF**

(30) Priority: 09.11.2010 JP 2010251014
(71) Applicant: Sharp Kabushiki Kaisha, Osaka-shi, Osaka 545-8522 (JP)
(72) Inventor: HASHIGUCHI, Hiroshi, Osaka-shi, Osaka 545-8522 (JP); ARAKI, Yasuhiro, Osaka-shi, Osaka 545-8522 (JP)
(74) Representative: Müller - Hoffmann & Partner
(86) International application number: PCT/JP2011/073924
(87) International publication number: WO 2012/063612

(57) **Abstract**

A solar cell module includes a framing member (20) formed of long-side frames (21) and short-side frames (25) that hold a peripheral edge portion of a solar cell panel (10), and a supporting member (30) disposed to straddle between the long-side frames (21). At both end portions in a longitudinal direction of a lower horizontal plate (32) of the supporting member (30), an engaging portion (32b) enlarged in a width direction by forming notches from both sides in the width direction. A lower plate (21d) of the long-side frame (21) has an inner-side edge portion (21d1) where a cut out portion (23) to which the engaging portion (32b) fits is formed. In a main plate (21a), a through hole is formed. A vertical main plate (33) of the supporting member (30) has, in a longitudinal direction, an end surface where a screw hole is disposed. The engaging portion (32b) fits the cut out portion (23), and a screw member (44) is inserted into the through hole and threadably mounted in the screw hole so as to secure the supporting member (30) between the long-side frames (21).

## Description

### TECHNICAL FIELD

The present invention relates to a solar cell module that includes a framing member, which holds a peripheral edge portion of a solar cell panel, and a supporting member, which is disposed across the framing members facing one another, and supports a back surface side of the solar cell panel. The present invention also relates to a method for manufacturing the solar cell module.

### BACKGROUND ART

As solar cell panels increase in size, the strength of a structure such as a framing member that supports the solar cell panel, especially, it has been important to ensure strength against a load in the vertical direction on a photo-receiving surface of the solar cell panel against a load.

Therefore, to ensure the strength of the solar cell panel against a load, a reinforcing member is disposed separately from the framing member to improve a load bearing performance in the vertical direction of the photo-receiving surface of the solar cell panel in a disclosed technique (for example, see Patent Literatures 1 and 2).

Patent Literature 1 discloses a solar cell module with the following structure. Long-side frame materials sandwich respective long sides of the framing member of the solar cell panel, between these frame materials, a reinforcing member that supports a back surface of a solar cell panel is disposed. This reinforcing member is secured to a level difference portion of each long-side frame material with screws and secured to the back surface of the solar cell panel with an adhesion material.

To describe more specifically, the reinforcing member has both end portions that each have an extending portion where a screw hole for mounting the frame material is formed. Each long-side frame material has a level difference portion for securing the extending portion. The reinforcing member is mounted with the following structure. following structure. The reinforcing member is attached to a weather-resistant film on the back surface in a position that divides the long side by two in the solar cell panel using an adhesive with weather resistance such as silicone resin. The extending portion is secured to the center of the long-side side of the level difference portion in each long-side frame material with screws from the back surface.

Patent Literature 2 discloses a solar cell module with the following structure. The structure includes a rim-shaped frame (a framing member) in an approximately rectangular shape and a reinforcing frame (a reinforcing member). The rim-shaped frame surrounds an outer edge of the solar cell panel over the entire circumference and supports the outer edge. The reinforcing frame is disposed across two sides facing each other in the rim-shaped frame, arranged with a predetermined gap between the reinforcing frame and the back surface of the solar cell panel, and supports the solar cell panel such that the reinforcing frame is brought into contact with the back surface of the solar cell panel in the case where the solar cell panel is warped. Both end portions of the reinforcing frame has a structure that fits a fitting cut out portion formed at an inner flange portion of the rim-shaped frame. This fitting cut out portion has a structure where the entire inner flange portion is cut out corresponding to a width of the end portion of the reinforcing frame.

### CITATION LIST

### PATENT LITERATURE

PATENT LITERATURE 1: Japanese Unexamined Patent Application Publication No. H9-148612
PATENT LITERATURE 2: W02008/139610

### SUMMARY OF INVENTION

### TECHNICAL PROBLEM

In the solar cell module disclosed in Patent Literature 1, a procedure for securing the reinforcing member to the long-side frame material is not described. Especially, as described in Patent Literature 2, in the rim-shaped frame with the inner flange portion, it is necessary to devise a measure for securing the reinforcing member to the frame material without interference between the inner flange portion and the reinforcing reinforcing member. For example, the solar cell panel is secured to the long-side frame material, and at the same time the reinforcing member and the long-side frame material are secured together (which is referred to as Method 1). Alternatively, the solar cell panel is secured to the long-side frame material. Subsequently, the reinforcing member is inclined to avoid the inner flange portion, and at the same time the reinforcing member is turned and inserted into a position between the solar cell panel, which is disposed between the long-side frame materials, and the inner flange portion (which is referred to as Method 2). These operations are necessary. In the case of Method 1, it is necessary to simultaneously secure the solar cell panel, the framing member, and the reinforcing member at the same time. Accordingly, there has been a problem in that its operation becomes considerably complicated and causes reduction in productivity. In the case of Method 2, it is necessary to slightly shorten a length of the reinforcing member so as to turn and insert the reinforcing member. This causes a gap between the inner wall of the long-side frame material and the end portion of the reinforcing member. Accordingly, there has been a problem in that strength between the framing member and the reinforcing member is reduced.

On the other hand, in the solar cell module as disclosed in Patent Literature 2, the above-described problem does not occur. However, to secure the reinforcing frame to the rim-shaped frame, the reinforcing frame is secured with at least two screws for each end portion at one side, in total, with four screws. There has been a problem in that securing with screws takes time. The position to mount the reinforcing frame is preferred to equally divide the rim-shaped frame in the longitudinal direction of the long-side frame. In case of one reinforcing frame, the position will be in approximately the center of the long-side frame. The center portion of the long-side frame is most easily deformed by the load on the solar cell panel. There has been a problem in that providing a wide cut out with the inner flange portion of the long-side frame in this portion may cause reduction in long-term strength of the long-side frame. Additionally, in a module manufacturing process, the reinforcing frame and the long-side frame cannot be temporarily secured. There has been a problem in that this makes securing with screws difficult and causes reduction in productivity.

The present invention has been made to solve these problems, and its object is to to provide a solar cell module that maintains a load bearing performance on the solar cell panel over a long period and is manufactured without reduction in productivity and to provide a method for manufacturing this solar cell module.

### SOLUTIONS TO THE PROBLEMS

To solve the above-described problem, a solar cell module according to the present invention includes a framing member and a supporting member. The framing member holds a peripheral edge portion of a solar cell panel. The supporting member is arranged on a back surface side of the solar cell panel so as to straddle between the opposing framing members. The framing member includes a frame-side main plate and a frame-side lower plate. The frame-side main plate has a holding plate portion that holds an edge portion of the solar cell panel. The frame-side lower plate is disposed to extend so as to face the holding plate portion from an edge portion of the frame-side main plate. The supporting member includes a support-side main plate and a support-side lower plate. The support-side lower plate is disposed at one edge portion in a short direction of the support-side main plate so as to make a right angle with the support-side main plate. The support-side lower plate includes an engaging portion at both end portions in a longitudinal direction. The engaging portion has a portion in a shape with a width larger toward an end portion in the longitudinal direction. The frame-side lower plate has an inner-side edge portion where a cut out portion is formed. The cut out portion fits the engaging portion. The frame-side main plate has a through hole, and the support-side main plate has, in the longitudinal direction, an end surface where a screw hole is formed. The engaging portion fits the cut out portion, and a screw member is inserted into the through hole and threadably mounted on the screw hole so as to secure the supporting member to the framing member.

With the present invention having this feature, fitting of the cut out portion and the engaging portion and threadably mounting the screw member in the screw hole allows strongly securing the supporting member to the framing member. Fitting the engaging portion to the cut out portion allows temporarily securing the supporting member to the framing member. This facilitates subsequent screw fixation using the screw member to the screw hole.

The solar cell module according to the present invention may have the following configuration. The engaging portion has a portion with a narrow width. The portion is formed by forming a notch at least at one side in a width direction of the support-side lower plate. More specifically, it is preferred that the engaging portion and the cut out portion be each formed in a T shape in plan view.

The solar cell module according to the present invention may have the following configuration. The through hole is formed in the frame-side main plate between the holding plate portion and the frame-side lower plate in a position closer to the holding plate portion than the frame-side lower plate. Thus, the through hole is formed in the position closer to the holding plate portion than the frame-side lower plate and a screwing position is arranged close to the solar cell panel. This ensures strength not only against a positive load (a load on the solar cell panel from a photo-receiving surface side) on the solar cell panel but also against a negative load.

The solar cell module according to the present invention may have the following configuration. The frame-side main plate and the end surface of the support-side main plate are secured with a screw in one position.

The solar cell module according to the present invention has a fitting structure between the cut out portion and the engaging portion that fits and secures the engaging portion formed in the support-side lower plate at both end portions in a longitudinal direction of the supporting member to the cut out portion formed in the frame-side lower plate of the framing member. Accordingly, screw fixation between the frame-side main plate and the support-side main plate maintains sufficient strength even if the frame-side main plate and the support-side main plate are secured at only one position.

The solar cell module according to the present invention may have the following configuration. At least a part of a surface that faces the solar cell panel at both the end portions in the longitudinal direction of the supporting member is supported by the holding plate portion of the framing member. At least a part of the surface that faces the solar cell panel at both the end portions in the longitudinal direction of the supporting direction of the supporting member is supported by the holding plate portion of the framing member. When the supporting member fits into the framing member, this allows facilitated alignment of the surface of the engaging portion of the support-side lower plate and the surface of the cut out portion of the frame-side lower plate.

The solar cell module according to the present invention may have the following configuration. The supporting member includes a support-side upper plate. The support-side upper plate is disposed to face the support-side lower plate parallel to each other across the support-side main plate. With the support-side upper plate, the cross section of the supporting member is formed in an H shape, thus improving rigidity against warping and twisting.

The solar cell module according to the present invention may have the following configuration. Both end portions in a longitudinal direction of the support-side upper plate are supported by the holding plate portion of the framing member. Both the end portions of the support-side upper plate of the supporting member are supported by the holding plate portion (the lower-side holding plate) of the framing member. Accordingly, when the supporting member fits the framing member, this allows facilitated alignment of the surface of the engaging portion of the support-side lower plate and the surface of the cut out portion of the frame-side lower plate.

A method for manufacturing each solar cell module with the above-described configuration according to the present invention includes: holding the edge portion of the solar cell panel in the holding plate portion of the framing member so as to hold the peripheral edge portion of the solar cell panel with the framing member; fitting the engaging portion formed in the support-side lower plate of the supporting member to the cut out portion formed in the frame-side lower plate of the framing member; and inserting the screw member into the through hole and threadably mounting the screw member in the screw hole so as to secure the supporting member to the framing member.

With the present invention having this feature, fitting of the cut out portion and the engaging portion and threadably mounting the screw member in the screw hole allows strongly securing the supporting member to the framing member. Fitting the engaging portion to the cut out portion allows temporarily securing the supporting member to the framing member. This facilitates subsequent screw fixation using the screw member, thus improving productivity.

### ADVANTAGEOUS EFFECTS OF INVENTION

With the present invention, fitting of the cut out portion and the engaging portion and threadably mounting the screw member to the screw hole allows strongly securing the supporting member to the framing member. This maintains a load bearing performance on the solar cell panel over a long period. Fitting the engaging portion to the cut out portion allows temporarily securing the supporting member to the framing member. This facilitates subsequent screw fixation using the screw member. Additionally, a fitting structure between the engaging portion and the cut out portion prevents wobbling of the supporting member to a direction (especially, a direction from the outer-side edge portion of the frame-side lower plate toward the inner-side edge portion) parallel to the back surface of the solar cell panel. This provides uniform and stable screw fixation at both the end portions in the longitudinal direction of the supporting member. Thus, this method manufactures the solar cell module without a reduction in productivity.

### BRIEF DESCRIPTION OF DRAWINGS

[Fig. 1] FIG. 1 is a perspective view illustrating an overall configuration of a solar cell module according to an embodiment, and also a view viewed from a back surface side (an opposite side of a photo-receiving surface) of a solar cell panel.
[Fig. 2] FIG. 2 is a cross-sectional view of an end portion of the solar cell panel.
[Fig. 3A] FIG. 3A is a bottom view of a long-side frame that constitutes a framing member.
[Fig. 3B] FIG. 3B is a front view of the long-side frame that constitutes the framing member.
[Fig. 3C] FIG. 3C is a side view of the long-side frame that constitutes the framing member.
[Fig. 4A] FIG. 4A is a bottom view of a short-side frame that constitutes the framing member.
[Fig. 4B] FIG. 4B is a front view of the short-side frame that constitutes the framing member.
[Fig. 4C] FIG. 4C is a side view of the short-side frame that constitutes the framing member.
[Fig. 5A] FIG. 5A is a bottom view of a supporting member.
[Fig. 5B] FIG. 5B is a front view of the supporting member.
[Fig. 5C] FIG. 5C is a side view of the supporting member.
[Fig. 6] FIG. 6 is an exploded perspective view of portion A in FIG. 1.
[Fig. 7] FIG. 7 is an exploded perspective view of portion B in FIG. 1.
[Fig. 8] FIG. 8 is a perspective view of portion B in FIG. 1.
[Fig. 9] FIG. 9 is a cross-sectional view taken along the line C-C of FIG. 8.
[Fig. 10A] FIG. 10A is an explanatory view illustrating another shape of an engaging portion and a cut out portion.
[Fig. 10B] FIG. 10B is an explanatory view illustrating another shape of an engaging portion and a cut out portion.
[Fig. 10C] FIG. 10C is an explanatory view illustrating another shape of an engaging portion and a cut out portion.
[Fig. 10D] FIG. 10D is an explanatory view illustrating another shape of an engaging portion and a cut out portion.
[Fig. 10E] FIG. 10E is an explanatory view illustrating another shape of an engaging portion and a cut out portion.
[Fig. 10F] FIG. 10F is an explanatory view illustrating another shape of an engaging portion and a cut out portion.
[Fig. 10G] FIG. 10G is an explanatory view illustrating another shape of an engaging portion and a cut out portion.
[Fig. 10H] FIG. 10H is an explanatory view illustrating another shape of an engaging portion and a cut out portion.

### DESCRIPTION OF EMBODIMENTS

Hereinafter, embodiments according to the present invention will be described with reference to the accompanying drawings.

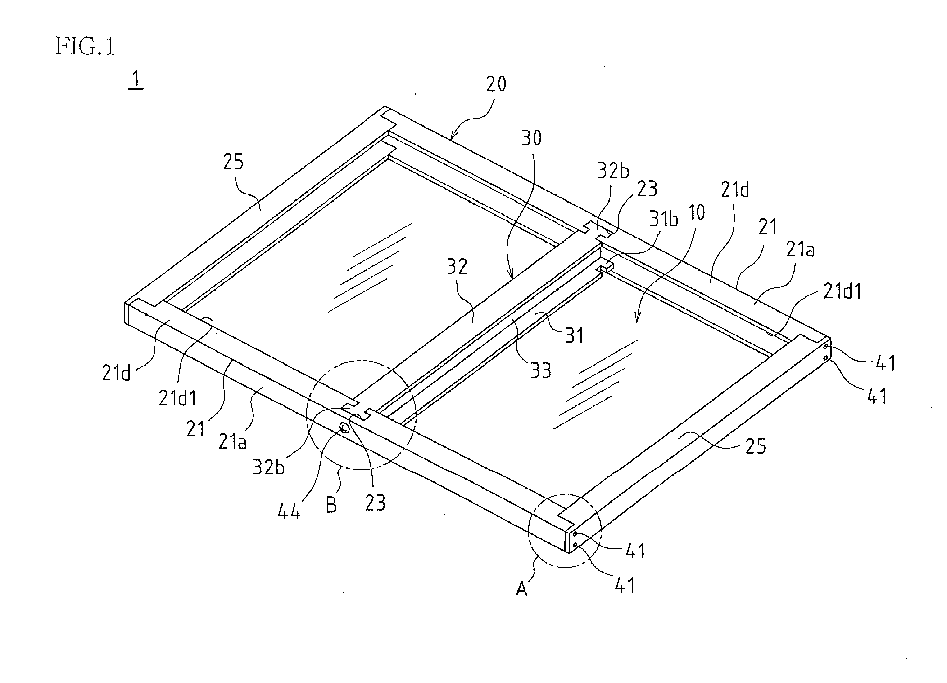

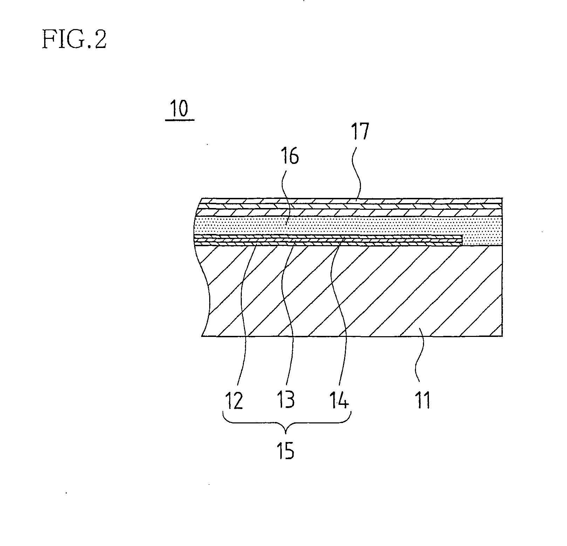

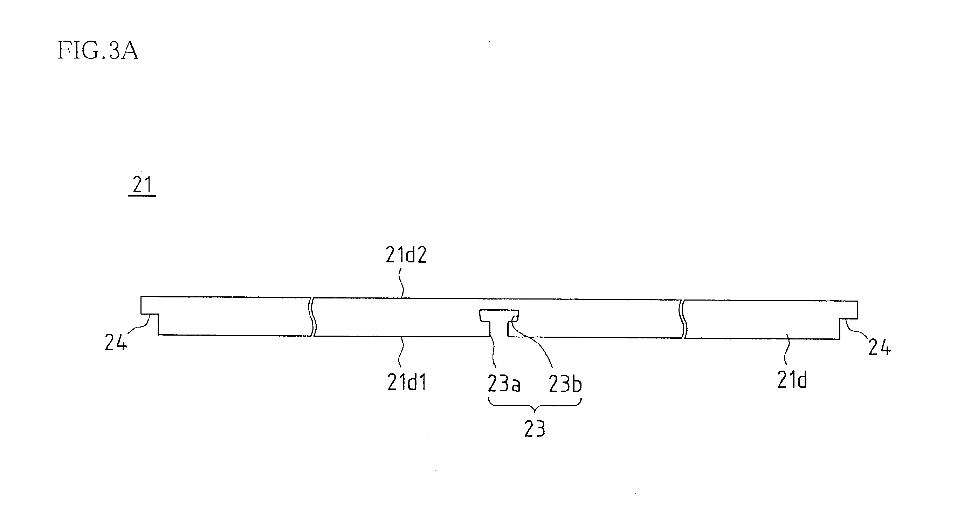

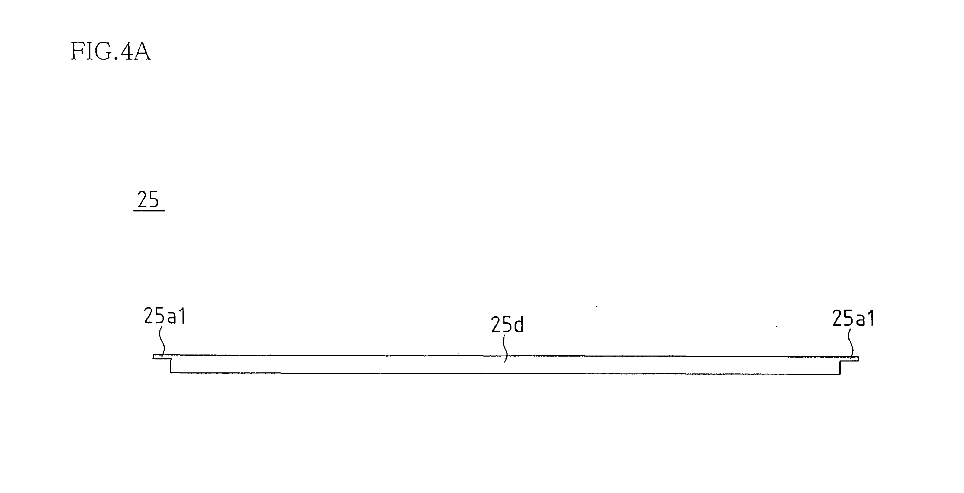

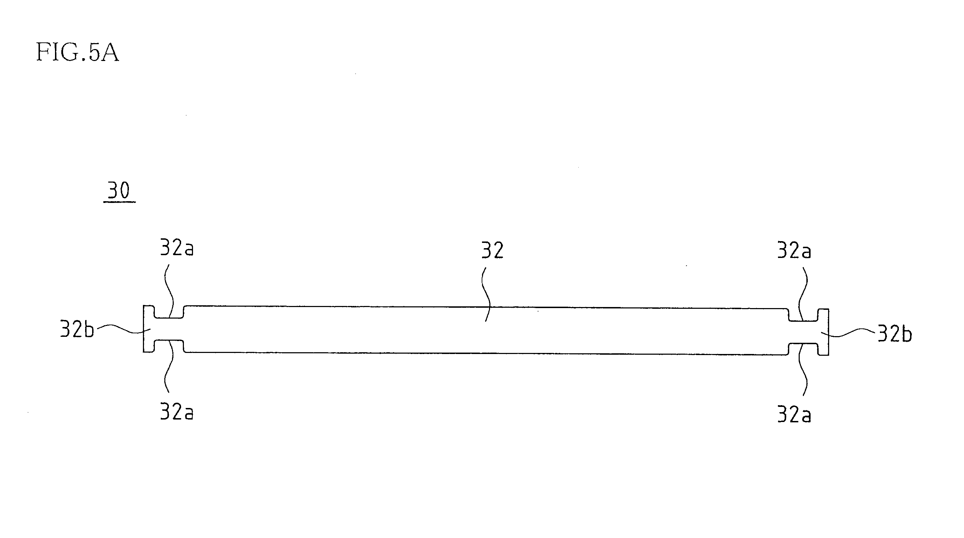

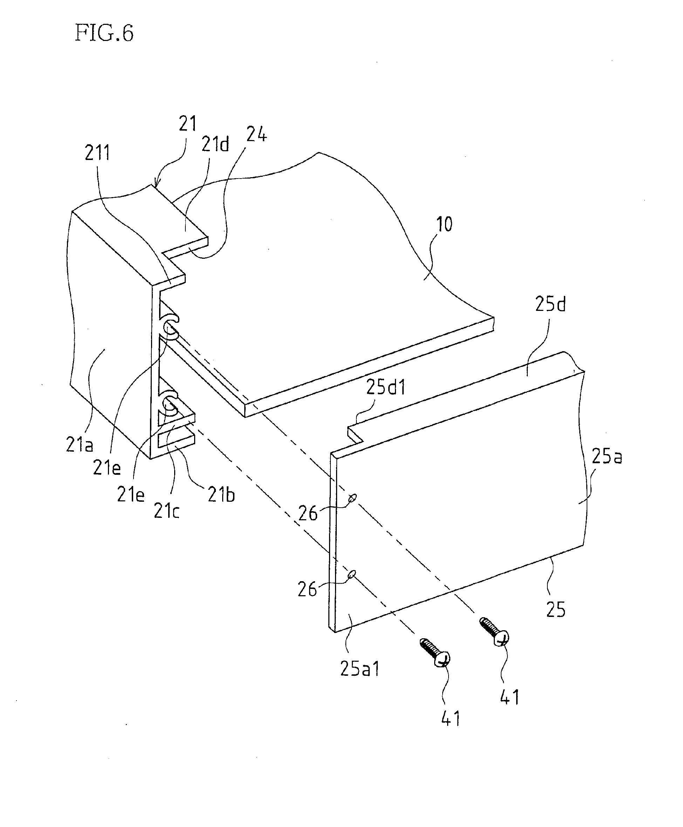

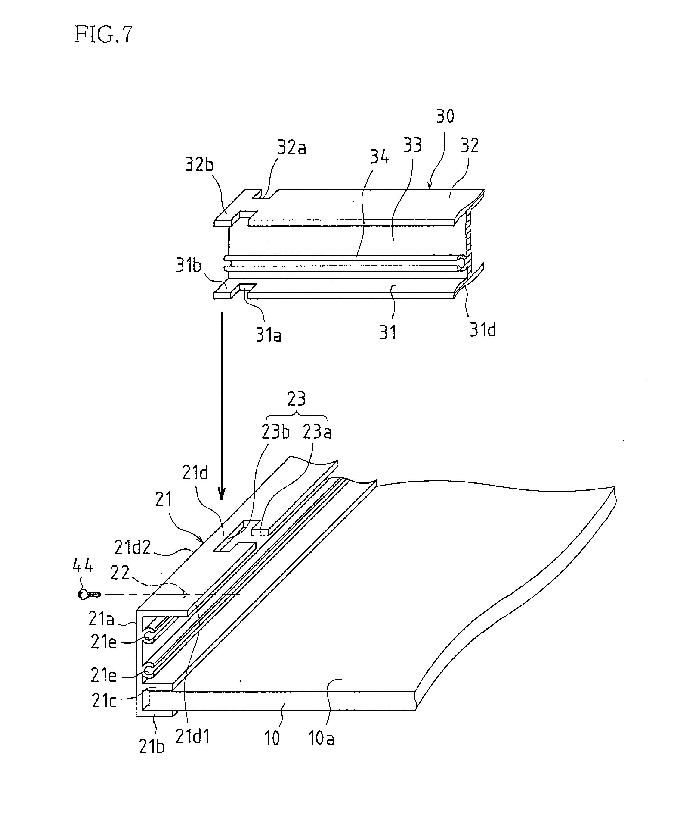

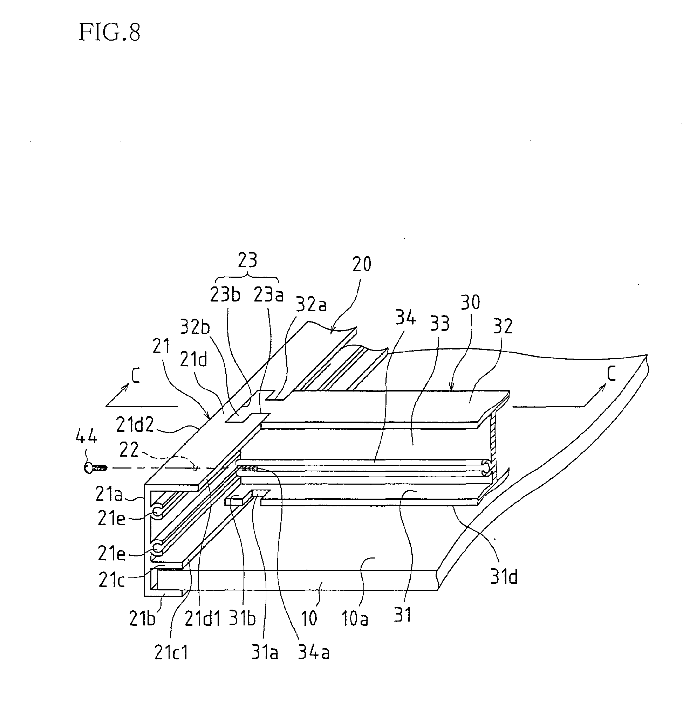

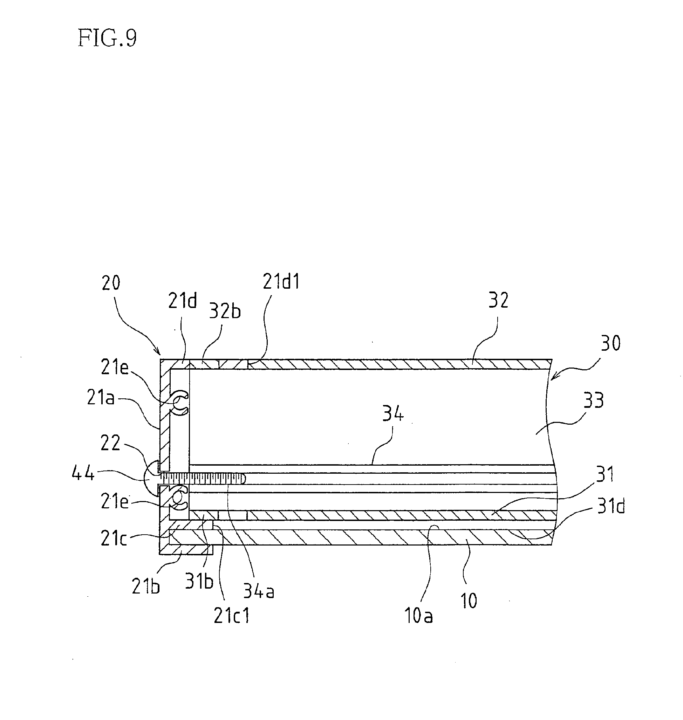

FIG. 1 is a perspective view illustrating an overall configuration of a solar cell module according to an embodiment. However, FIG. 1 is a view viewed from a back surface side of a solar cell panel, that is, an opposite side of a photo-receiving surface. FIG. 2 is a cross-sectional view of an end portion of the solar cell panel. FIGS. 3A to 3C are a bottom view, a front view, and side view of a long-side frame that constitutes a framing member. FIGS. 4A to 4C are a bottom view, a front view, and a side view of a short-side frame that constitutes the framing member. FIGS. 5A to 5C are a bottom view, a front view, and a side view of a supporting member. FIG. 6 is an exploded perspective view of portion A in FIG. 1. FIG. 7 is an exploded perspective view of portion B in FIG. 1. FIG. 8 is a perspective view of portion B in FIG. 1. FIG. 9 is a cross-sectional view taken along the line C-C of FIG. 8.

As illustrated in FIG. 1, a solar cell module 1 of this embodiment includes a solar cell panel 10, a framing member 20 that holds a peripheral edge portion of the solar cell panel 10, and one supporting member 30 secured to this framing member 20.

As illustrated in a partially enlarged cross section of this end portion in FIG. 2, the solar cell panel 10 has the following structure. On a transparent insulating substrate (a surface substrate) 11, a solar battery cell 15 is constituted such that a transparent electrode film 12 formed of a transparent conductive film, a photoelectric conversion layer 13, and a back surface electrode film 14 are laminated in this order. Additionally, on this back surface electrode film 14, a sealing film (a sealing material) 16 and a back film 17 as a back-surface protective sheet to provide weather resistance and high insulation property are laminated. The solar cell panel 10 has an integral structure where the transparent insulating substrate 11, the transparent electrode film 12, the photoelectric conversion layer 13, the back surface electrode film 14, the sealing film (the sealing material) 16, and the back film 17 are all laminated and sealed.

The solar cell panel is not limited to the above-described configuration. For example, the solar battery cell employs a single crystal wafer, a polycrystalline wafer, and a similar wafer. Along with a conductive member coupled to an electrode formed on the front surface and/or the back surface of the solar battery cell, the solar battery cell is laminated and sealed with the sealing film (the sealing material) between the transparent insulating substrate (the surface substrate) and the back film. Like this structure, a photovoltaic generation panel with a translucent substrate on its surface may surface may be employed.

The transparent insulating substrate 11 employs heat resistant resin such as glass and polyimide. The transparent electrode film 12 employs SnO2, ZnO, ITO (indium tin oxide), or a similar material. The photoelectric conversion layer 13 employs a silicon-based photoelectric conversion film such as amorphous silicon and microcrystalline silicon and a compound-based photoelectric conversion film such as CdTe and CuInSe2. The back surface electrode film 14 is, for example, formed of a ZnO transparent conductive film and a thin silver film. The sealing film 16 is preferred to be a thermoplastic polymer film. Especially, the sealing films made of EVA (ethylene-vinyl acetate resin), PVB (polyvinyl butyral resin), and similar material are suitable. The back film 17 is preferred to be a film that has weather resistance, moisture resistance, and high electrical insulating property, and may employ a PET (polyethylene terephthalate) film, a PEN (polyethylene naphthalate) film, a PVF (polyvinyl fluoride) film, and a similar film. These films may be formed in a multiple layer structure to additionally improve weather resistance. Between a plurality of films with the multiple layer structure, a metal film such as an aluminum film may be interposed.

As illustrated in FIG. 1, the framing member 20 holds four sides of the solar cell panel 10 and includes a pair of long-side frames 21 and a pair of short-side frames 25. The framing member 20 is formed in a frame shape by integrally assembling these frames 21 and 25. The respective frames 21 and 25 are formed by extruding aluminum.

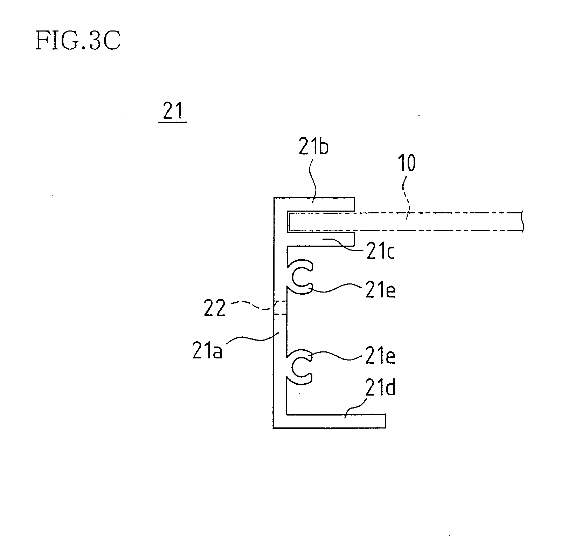

Next, a configuration of the long-side frame 21 will be described by referring to FIG. 3A to FIG. 3C. However, in the cross-sectional view of FIG. 3C, a left side of the long-side frame 21 is referred to as an outside that constitutes an outer edge of the solar cell panel 10, and a right side of the long-side frame 21 is referred to as a side that supports the solar cell panel 10, that is an inner side in this description.

As illustrated in FIG. 3A to FIG. 3C, the long-side frame 21 includes a main plate 21a that is vertically disposed upright and extend in the longitudinal direction. In the long-side frame 21, an upper-side holding plate 21b is disposed to extend from an an upper end portion of this main plate 21a to the inner side (the right side in FIG. 3C). In the long-side frame 21, a lower-side holding plate 21c is disposed to extend from an inner side surface of the main plate 21a in a lower position with respect to this upper-side holding plate 21b by a predetermined distance to the inner side (the right side in FIG. 3C) similarly. That is, the upper-side holding plate 21 b and the lower-side holding plate 21c c constitute a holding plate portion that engages and holds a long-side outer periphery end of the solar cell panel 10. Accordingly, a width dimension (dimensions in the vertical direction in FIG. 3C) between the upper-side holding plate 21b and the lower-side holding plate 21 c is set slightly larger than a thickness dimension (dimensions in the vertical direction in FIG. 2) of the solar cell panel 10.

From a lower end portion of the main plate 21 a to the inner side (the right side in FIG. 3C), a lower plate 21d is disposed to extend. This lower plate 21d has an extended length longer than the upper-side holding plate 21b and the lower-side holding plate 21c.

The main plate 21 a has the inner side surface where screw mounting portions 21 e with a screw hole for coupling to the short-side frame 25 is disposed in two positions in the vertical direction along the longitudinal direction.

In the main plate 21 a, a through hole 22 is disposed at the center portion in the longitudinal direction. This through hole 22 is a hole for screwing a screw member into a screw mounting portion 34 of the supporting member 30, which will be described later, from outside of the main plate 21a. More specifically, the through hole 22 is formed in the main plate 21a between the holding plate portion (the lower-side holding plate 21c) and the lower plate 21d and in a position closer to the lower-side holding plate 21c than the lower plate 21d. Thus, the through hole 22 is formed in the position closer to the lower-side holding plate 21c than the lower plate 21d to have a screwing position close to the solar cell panel 10. This ensures strength not only against a positive load (a load on the solar cell panel 10 from the photo-receiving surface side) on the solar cell panel 10 but also against a negative load (a load of the solar cell panel 10 from the back surface side).

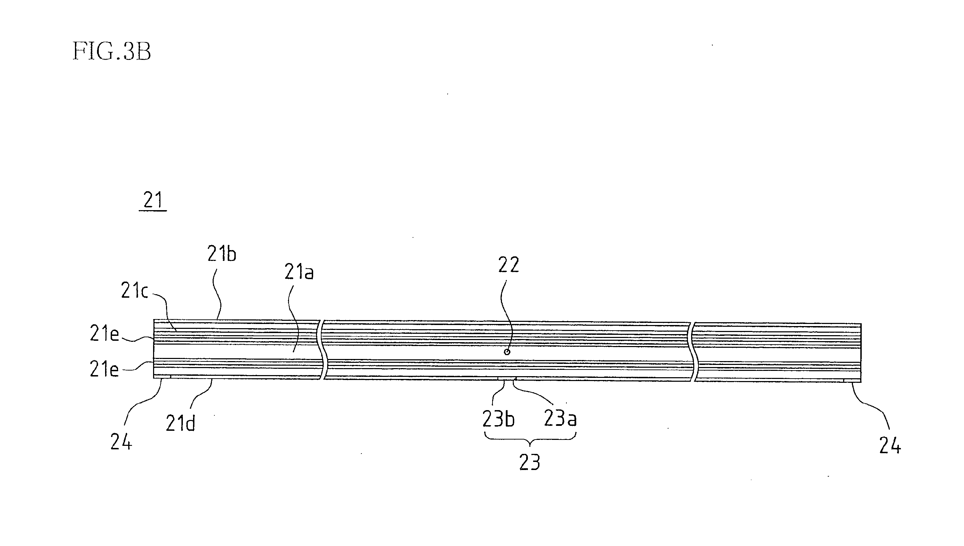

In the lower plate 21d, as illustrated in FIG. 3A and FIG. 3B, a cut out portion 23 is disposed at the center portion in the longitudinal direction. This cut out portion 23 is a portion to which an engaging portion 32b of the supporting member 30 described later fits. In the cut out portion 23, a first cut out portion 23a with a narrow width is formed from an inner-side edge portion 21d1 of the lower plate 21d. In the cut out portion 23, a second cut out portion 23b with a larger width than the width of the first cut out portion 23a formed continuously toward the inner side (a side toward an outer-side edge portion 21d2 of the lower plate 21d) of the first cut out portion 23a is formed. The cut out portion 23 has a T-shaped cut out shape in plan view as a whole. The engaging portion of the supporting member, which is described later, engages this cut out portion 23 to allow the engaging portion 32b of the supporting member 30 to suppress deformation of the cut out portion 23. Especially, in the case where the supporting member 30 is disposed at the center in the longitudinal direction of the framing member 20, this portion receives the maximum load of the solar cell panel 10. Thus, disposing the cut out portion in this portion may cause deformation of the lower plate 21d in this portion. With the above-described configuration, the cut out portion 23 engages the engaging portion 32b of the supporting member 30. Accordingly, even if the cut out portion 23 receives a deformation stress, the engaging portion 32b of the supporting member 30 prevents its deformation. This maintains sufficient strength of the framing member 20.

At both end portions in the longitudinal direction of the lower plate 21d, an end cut out portion 24, which is cut out in an L shape, is formed.

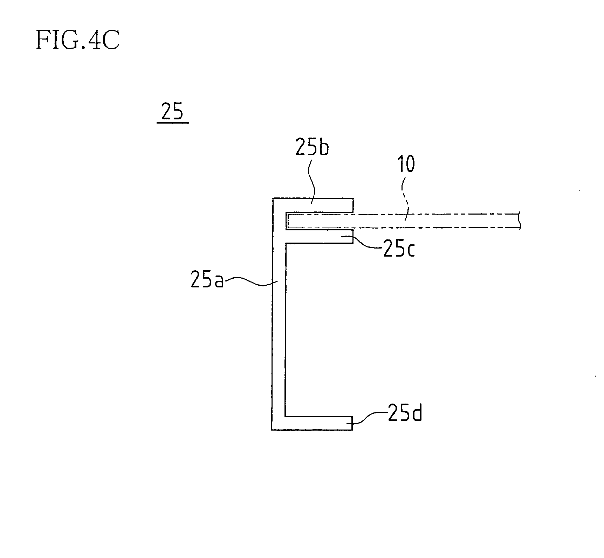

Next, a configuration of the short-side frame 25 will be described by referring to FIG. 4A to FIG. 4C. However, in the cross-sectional view of FIG. 4C, a left side of the short-side frame 25 is referred to as an outside that constitutes an outer edge of the solar cell panel 10, and a right side of the short-side frame 25 is referred to as a side that supports the solar cell panel 10, that is an inner side in this description.

As illustrated in FIG. 4A to FIG. 4C, the short-side frame 25 includes a main plate 25a that is vertically disposed upright and extends in the longitudinal direction. In the short-side frame 25, an upper-side holding plate 25b is disposed to extend from an an upper end portion of this main plate 25a to the inner side (the right side in FIG. 4C). In the short-side frame 25, a lower-side holding plate 25c is disposed to extend from an inner side surface of the main plate 25a in a lower position with respect to the upper-side holding plate 25b by a predetermined distance to the inner side (the right side in FIG. 4C) similarly. That is, the upper-side holding plate 25b and the lower-side holding plate 25c constitute a holding plate portion that engages and holds a short-side outer periphery end of the solar cell panel 10. Accordingly, a width dimension (dimensions in the vertical direction in FIG. 4C) between the upper-side holding plate 25b and the lower-side holding plate 25c is set slightly larger than a thickness dimension (dimensions in the vertical direction in FIG. 2) of the solar cell panel 10.

From a lower end portion of the main plate 25a to the inner side (the right side in the drawing), a lower plate 25d is disposed to extend. This lower plate 25d has an extended length that may be the same (approximately the same) as extended lengths of the upper-side holding plate 25b and the lower-side holding plate 25c and is preferred to be longer than the upper-side holding plate 25b and the lower-side holding plate 25c. This allows providing the supporting member, which will be described later, across the short-side frames 25.

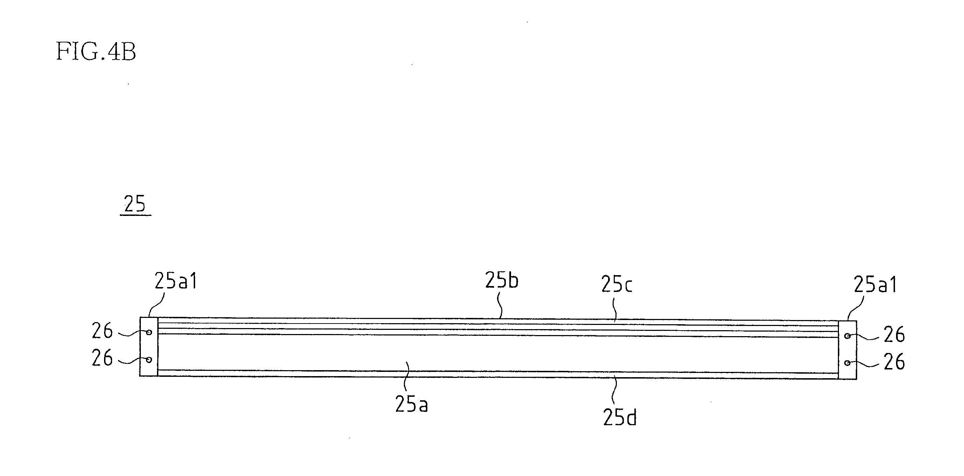

As illustrated in FIG. 4A and FIG. 4B, both the end portions in the longitudinal direction of the main plate 25a is disposed to extend longer than respective end portions of the upper-side holding plate 25b, the lower-side holding plate 25c, and the lower plate 25d in the longitudinal direction. This extended portion 25a1 has through holes 26 in two vertical positions that each face the screw mounting portion 21e disposed in the main plate 21 a.

Next, a configuration of the supporting member 30 will be described by referring to FIG. 5A to FIG. 5C.

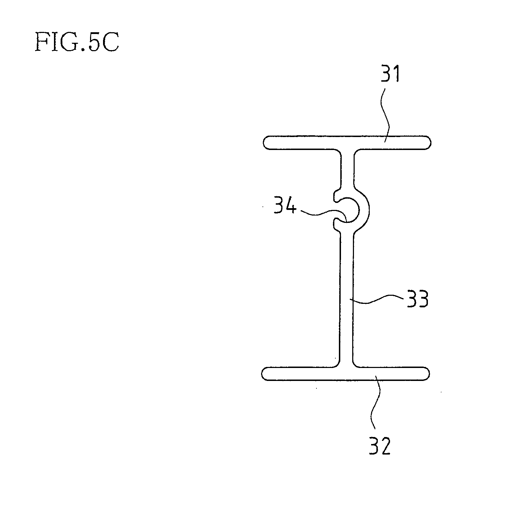

As illustrated in FIG. 5A to FIG. 5C, the supporting member 30 in this embodiment includes an upper horizontal plate 31, a lower horizontal plate 32, and a vertical main plate 33 that supports the center portions of both horizontal plates 31 and 32 along the longitudinal direction. The supporting member 30 has a shape (a shape illustrated in FIG. 5C) that is an H shape in the lateral direction from an end surface side. That is, the upper horizontal plate 31 and the lower horizontal plate 32 vertically face each other and are disposed parallel to each other. These plates are coupled by the vertical main plate 33 in this structure. Conversely, the supporting member 30 is constituted of the vertical main plate 33, the upper horizontal plate 31, and the lower horizontal plate 32. The upper horizontal plate 31 and the lower horizontal plate 32 are disposed in both the upper and lower edge portions in the short direction of the vertical main plate 33 to each make a right angle with this vertical main plate 33. This supporting member 30 is formed by extruding aluminum.

At both the end portions in the longitudinal direction of the upper horizontal plate 31 and the lower horizontal plate 32, respective engaging portions 31b and 32b in shapes with large widths toward the end portions in the longitudinal direction are formed. In this embodiment, the engaging portions 31b and 32b are formed in a T shape in plan view where the notch portions 31 a and 32a are formed from both sides in the width direction and the engaging portions 31b and 32b expand in the width direction. These engaging portions 31b and 32b each have a shape that approximately corresponds to the shape of the cut out portion 23 disposed in the lower plate 21d of the long-side frame 21 and allows the engaging portions 31b and 32b to fit the cut out portion 23 without wobbling. However, the engaging portion 31b disposed in the upper horizontal plate 31 of the supporting member 30 may have any configuration that can be inserted into the cut out portion 23 (that is, the engaging portion 31b has any configuration that can function as a guide plate for aligning). Accordingly, the engaging portion 31b may have any shape that allows passing the cut out portion 23, for example, may be formed slightly smaller than the cut out portion 23. The upper horizontal plate 31 is not necessary and maybe omitted. That is, the supporting member 30 may be constituted of the lower horizontal plate 32 and the vertical main plate 33 to have a T-shape viewed from the end surface side.

However, like this embodiment, disposing the upper horizontal plate 31 makes the cross section of the supporting member 30 in an H shape, thus improving rigidity against warping and twisting. Additionally, the supporting member at a side facing the back surface of the solar cell panel 10 becomes the upper horizontal plate 31 to form a planar surface. In view of this, even if the solar cell panel 10 is warped and the back the back surface of the solar cell panel 10 is brought into contact with the supporting member 30, the back surface of the solar cell panel 10 is supported by the planar surface. Accordingly, this prevents occurrence of strain, cell cracking, or a similar trouble due to a local pressure on the solar cell panel 10 as an advantage. Therefore, to the extent that rigidity against warping and twisting of the supporting member 30 is ensured, this allows decreasing the width of the upper horizontal plate 31 compared with the width of the lower horizontal plate 32. In this case, while retaining the above-described advantages, the material of the supporting member 30 can be reduced.

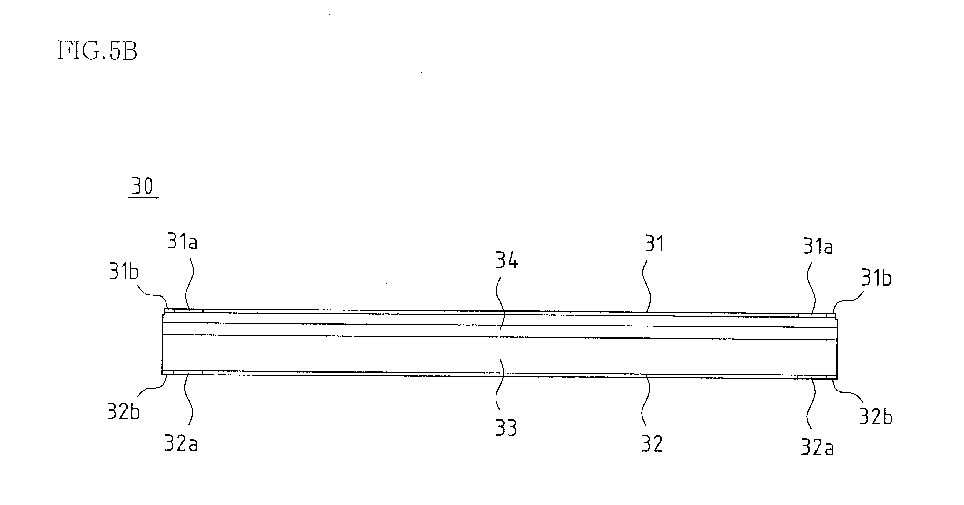

In the vertical main plate 33, the screw mounting portion 34 with the screw hole for coupling to the long-side frame 21 is disposed on the end surface in the longitudinal direction. More specifically, the screw mounting portion 34 is formed in a position between the upper horizontal plate 31 and the lower horizontal plate 32 and closer to the upper horizontal plate 31 than the lower horizontal plate 32. Thus, the screw mounting portion 34 formed in the position closer to the upper horizontal plate 31 than the lower horizontal plate 32 corresponds to a forming position of the through hole 22 formed in the main plate 21a of the long-side frame 21. In view of this, as described above, the screwing position is close to the solar cell panel 10. This ensures larger strength against positive and negative loads on the solar cell panel 10. While in FIG. 5B, as an example, the screw mounting portion 34 is formed along the longitudinal direction of the vertical main plate 33, the screw mounting portion 34 may be disposed in any position insofar as the screw mounting portion 34 is disposed at least on the end surface in the longitudinal direction of the vertical main plate 33.

The solar cell module 1 according to this embodiment is assembled using each member in the above-described configuration as follows. Hereinafter, an assembly process (a manufacturing process) will be described by referring to FIG. 6 to FIG. 9. However, FIG. 6 to FIG. 9 are drawings each in a state where the solar cell panel has the photo-receiving surface side on the bottom and the back surface side on the top.

First, the peripheral end portion of the solar cell panel 10 engages an end surface sealing member (not shown). This end surface sealing member has a frame shape formed along the outline of the end portion of the solar cell panel 10, and is for example, example, formed of elastomer resin. Subsequently, with the peripheral end portion of the solar cell panel 10 engaging this end surface sealing member, the upper-side holding plate 21b and the lower-side holding plate 21c of the long-side frame 21 and the upper-side holding plate 25b and the lower-side holding plate 25c of the short-side frame 25 are each engaged. Subsequently, as illustrated in FIG. 6, the screw mounting portion 21 e of the long-side frame 21 is faced to the through hole 26 of the short-side frame 25, and a screw member 41 is screwed into the screw mounting portion 21 e through the through hole 26. Accordingly, in a state where the solar cell panel 10 is held, the long-side frame 21 and the short-side frame 25 are integrally secured with screw. Accordingly, the end surface 211 in the longitudinal direction of the long-side frame 21 is brought into contact with the extended portion 25a1 of the short-side frame 25. The end cut out portion 24 formed at an end portion of the lower plate 21d of the long-side frame 21 fits the end portion 25d1 of the lower plate 25d of the short-side frame 25. Subsequently, the long-side frame 21 and the short-side frame 25 are integrally assembled.

Subsequently, as illustrated in FIG. 7, in a state where the front surface side of the solar cell panel 10 is at the bottom, the solar cell panel 10 and the framing member 20 are disposed. In this state, the cut out portion 23 formed in the lower plate 21d of the long-side frame 21 allows a passage of the engaging portion 31b formed in the upper horizontal plate 31 of the supporting member 30 while fitting the engaging portion 31b from the upper portion. Then, the engaging portion 31b is lowered to the back surface side of the solar cell panel 10. Accordingly, as illustrated in FIG. 8, the engaging portion 32b formed in the lower horizontal plate 32 of the supporting member 30 fits the cut out portion 23 formed in the lower plate 21 d of the long-side frame 21.

At this time, as illustrated in FIG. 8 and FIG. 9, both the end portions (the engaging portions 31b formed at both the end portions in the longitudinal direction of the upper horizontal plate 31 in this embodiment) in the longitudinal direction of the upper horizontal plate 31 of the supporting member 30 is supported in contact with the upper surface of the lower-side holding plate 21c of the long-side frame 21. This retains the engaging portion 32b of the lower horizontal plate 32 of the supporting member 30 held in a state fitting the cut out portion 23 of the lower plate 21d of the long-side frame 21, long-side frame 21, thus preventing pulling out of the engaging portion 32b in the vertical direction. Additionally, the fitting structure of the engaging portion 32b formed in a T shape in plan view and the cut out portion 23 prevents wobbling of the supporting member 30 in a direction parallel to the back surface 10a of the solar cell panel 10.

The top surface (the upper horizontal plate 31) of the supporting member 30 is supported in contact with the holding plate portion (the lower-side holding plate 21 c) of the framing member 20. When the supporting member 30 fits into the framing member 20, this allows facilitated alignment of the surface of the engaging portion 32b of the lower horizontal plate 32 and the surface of the cut out portion 23 of the lower plate 21d. Therefore, this improves production efficiency and product quality. Additionally, the upper horizontal plate 31 is in contact with the holding plate portion (the lower-side holding plate 21 c) of the framing member 20 and supported with a length of its width. Accordingly, when the framing member 20 fits the supporting member 30, this prevents the supporting member 30 from rotating around its longitudinal direction. This further improves production efficiency. Additionally, a contacting portion between the upper horizontal plate 31 and the lower-side holding plate 21c of the holding plate portion becomes enlarged. This increases strength of the supporting member 30 and further improves product quality. In the case where the upper horizontal plate 31 is not disposed, the end portion of the vertical main plate 33 of the supporting member 30 is brought into contact with the lower-side holding plate 21c of the holding plate portion.

On the other hand, in this state, the through hole 22 formed in the main plate 21 a of the long-side frame 21 faces the screw mounting portion 34 disposed in the vertical main plate 33 of the supporting member 30. Accordingly, in this state, a screw member 44 is inserted into the through hole 22 formed in the main plate 21 a of the long-side frame 21 from outside of the long-side frame 21, and the screw member 44 is screwed into a screw hole of the screw mounting portion 34 facing the screw member 44 to be secured.

This fitting of the cut out portion 23 and the engaging portion 32b and threadably mounting the screw member 44 in the screw hole of the screw mounting portion 34 allows strongly securing the supporting member 30 between the long-side frames 21 of the framing member 20. Additionally, fitting the engaging portion 32b to the cut out portion 23 allows temporarily securing the supporting member 30 to the framing member 20. This facilitates this subsequent screw fixation using the screw member 44.

The fitting structure between the engaging portion 32b formed in a T shape in plan view and the cut out portion 23 prevents wobbling of the lower plate 21d of the long-side frame 21 in a direction from the outer-side edge portion 21 d2 toward the inner-side edge portion 21d1. Accordingly, this provides uniform and stable screw fixation at both the end portions in the longitudinal direction of the supporting member 30. In this embodiment, as described above, the supporting member 30 passes through the cut out portion 23 formed in the lower plate 21d of the long-side frame 21 from the upper portion and lowered to the back surface side of the solar cell panel 10, thus disposing the supporting member 30 between the long-side frames 21. Therefore, unlike the conventional technique of Method 2, the supporting member 30 need not have a slightly shorter length. Accordingly, as illustrated in FIG. 9, the length of the supporting member 30 can be set such that the end portion of the longitudinal direction of the supporting member 30 is brought into contact with the screw mounting portion 21e disposed on the inner side surface of the main plate 21a of the long-side frame 21.

That is, the supporting member 30 is not displaced to one end portion side. This keeps uniform fastening strength by the screw members 44 at both the end portions in the longitudinal direction of the supporting member 30, and provides a stable fastening state. This prevents the framing member 20 from warping due to fastening by the screw member 44. This allows uniformly supporting the solar cell panel 10 and constitutes the strong framing member 20 that suppresses warpage due to positive and negative loads on the solar cell panel 10. Accordingly, this ensures long-term reliability of the solar cell module 1.

In FIG. 9, the end portion of the longitudinal direction of the supporting member 30 is brought into contact with the screw mounting portion 21e disposed on the inner side surface of the main plate 21 a of the long-side frame 21. However, in the main plate 21a the main plate 21a of the long-side frame 21, a contacting portion with the end portion in the longitudinal direction of the supporting member 30 is not necessary to be the screw mounting portion 21e. The end portion in the longitudinal direction of the supporting member 30 may be directly brought into contact with the inner side surface of the main plate 21 a of the long-side frame 21.

In this embodiment, the through hole 22 is formed at one position in the width direction (the height direction) of the main plate 21a. The screw mounting portion 34 is also disposed at one position in the width direction (the height direction) of the vertical main plate 33. The engaging portion 32b is fitted and secured to the cut out portion 23 to prevent pulling out of the engaging portion 32b in the longitudinal direction. Accordingly, screw fixation between the main plate 21a of the long-side frame 21 and the vertical main plate 33 of the supporting member 30 maintains sufficient strength with only one position. The screw fixation between the long-side frame 21 and the supporting member 30 at one position (two positions on the right and left) reduces the number of screws used for coupling the framing member 20 and the supporting member 30 and reduces components and man-hour during manufacture, thus ensuring low-cost manufacturing. Additionally, one (two on the left and right) screw mounting portion 34 (screw hole) further reduces danger of rusting and possibility of cracking.

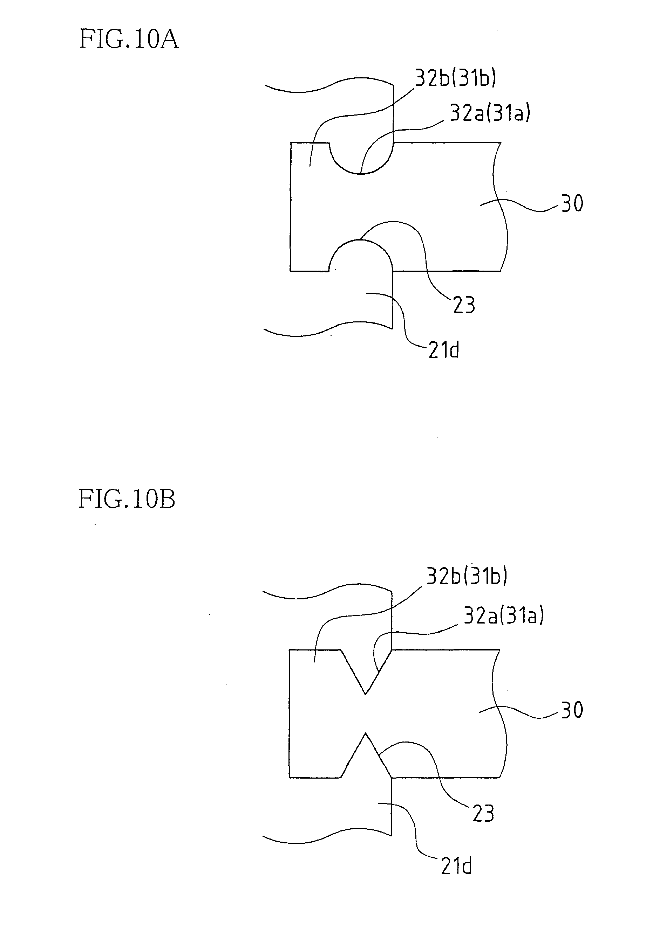

In the above-described embodiment the engaging portions 31b and 32b have notches from both sides in the width direction of the upper horizontal plate 31 and the lower horizontal plate 32 to form a T shape. However, the engaging portions 31b and 32b are not limited to this shape. For example, various shapes are possible as illustrated in FIG. 10A to FIG. 10H.

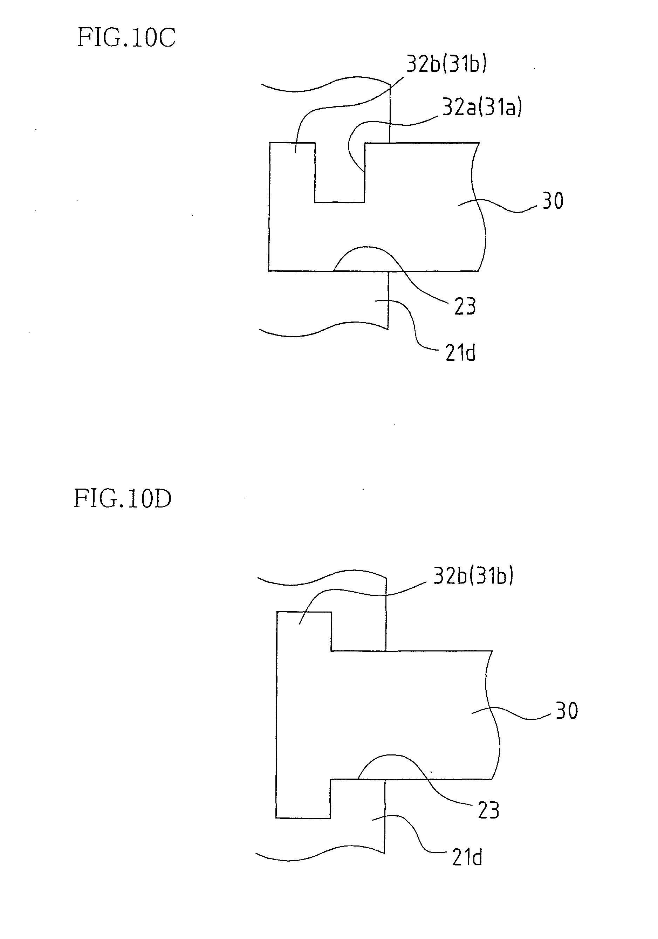

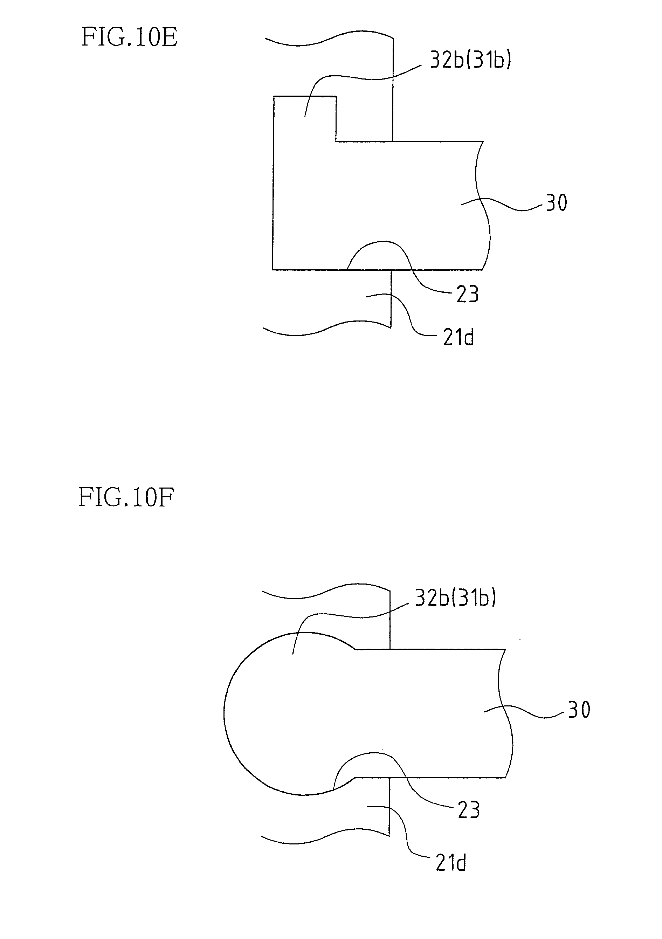

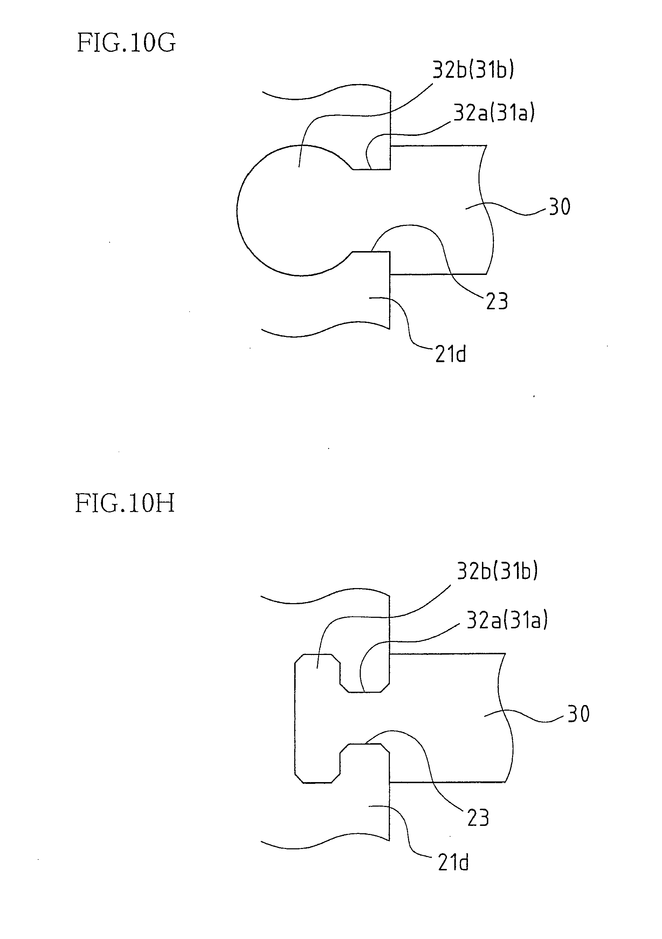

That is, FIG. 10A illustrates notch portions 31a and 32a with a shape of a semicircular arc. FIG. 10B illustrates notch portions 31a and 32a with a triangular shape. FIG. 10C illustrates notch portions 31 a and 32a formed at only one side in the width direction. FIG. 10D illustrates engaging portions 31b and 32b that are not cut out but are disposed to extend in the width direction from the both side in the width direction of the upper horizontal plate 31 and the lower horizontal plate 32. FIG. 10E illustrates engaging portions 31b and 32b that are not cut out but are disposed to extend in the width extend in the width direction from only one side in the width direction of the upper horizontal plate 31 and the lower horizontal plate 32. FIG. 10F illustrates engaging portions 31b and 32b that are also not cut out but are bulged in a disk shape at both the end portions from the upper horizontal plate 31 and the lower horizontal plate 32. FIG. 10G illustrates engaging portions 31b and 32b bulged in a disk shape at distal end sides of the notch portions 31a and 32a. FIG. 10H illustrates, in the above-described embodiment, notch portions 31a and 32a and engaging portions 31b and 32b that each have a concave/convex corner portion with a chamfered shape. Corresponding to these shapes of the notch portions 31 a and 32a, the cut out portion 23 formed in the lower plate 21 d of the long-side frame 21 is formed in a shape that fits the notch portions 31 a and 32a obviously. The examples illustrated in FIG. 10A to FIG. 10H are only one example, and not limited to these examples. The engaging portion 31b of the upper horizontal plate 31 may have any configuration in a shape that passes the cut out portion 23 formed in the lower plate 21d of the long-side frame 21, and may have a shape different from the shape of the engaging portion 32b of the lower horizontal plate 32.

The present invention can be embodied and practiced in other different forms without departing from the spirit and essential characteristics of the present invention. Therefore, the embodiments disclosed in this application are to be considered in all respects as illustrative and not limiting. The scope of the present invention is indicated by the appended claims rather than by the foregoing description. All variations and modifications falling within the meaning and range of equivalency of the claims are intended to be embraced in the scope of the present invention.

This application is based on and claims priority to Japanese Patent Application 2010-251014, filed on November 19, 2010, the entire contents of which are incorporated herein by reference.

### DESCRIPTION OF REFERENCE SIGNS

- 1: solar cell module
- 10: solar cell panel
- 11: transparent insulating substrate
- 12: transparent electrode film
- 13: photoelectric conversion layer
- 14: back surface electrode film
- 15: solar battery cell
- 16: sealing film (sealing material)
- 17: back film (back-surface protective sheet)
- 20: framing member
- 21: long-side frame
- 21a: main plate (frame-side main plate)
- 21b: upper-side holding plate
- 21c: lower-side holding plate
- 21c1: inner-side edge portion (inner-side end surface)
- 21d: lower plate (frame-side lower plate)
- 21d1: inner-side edge portion
- 21d2: outer-side edge portion
- 21e: screw mounting portion
- 22: through hole
- 23: cut out portion
- 23a: first cut out portion
- 23b: second cut out portion
- 24: end cut out portion
- 25: short-side frame
- 25a: main plate (frame-side main plate)
- 25a1: extended portion
- 25b: upper-side holding plate
- 25c: lower-side holding plate
- 25d: lower plate (frame-side lower plate)
- 26: through hole
- 30: supporting member
- 31: upper horizontal plate (support-side upper plate)
- 32: lower horizontal plate (support-side lower plate)
- 33: vertical main plate (support-side main plate)
- 31a and 32a: notch portion
- 31b and 32b: engaging portion
- 31b1: end surface
- 34: screw mounting portion
- 34a: screw hole
- 41 and 44: screw member

## Claims

1. A solar cell module comprising:
a framing member that holds a peripheral edge portion of a solar cell panel; and
a supporting member arranged on a back surface side of the solar cell panel so as to straddle between the opposing framing members, wherein
the framing member includes a frame-side main plate and a frame-side lower plate, the frame-side main plate having a holding plate portion that holds an edge portion of the solar cell panel, the frame-side lower plate being disposed to extend so as to face the holding plate portion from an edge portion of the frame-side main plate,
the supporting member includes a support-side main plate and a support-side lower plate, the support-side lower plate being disposed at one edge portion in a short direction of the support-side main plate so as to make a right angle with the support-side main plate,
the support-side lower plate includes an engaging portion at both end portions in a longitudinal direction, the engaging portion having a portion in a shape with a width larger toward an end portion in the longitudinal direction, the frame-side lower plate having an inner-side edge portion where a cut out portion is formed, the cut out portion fitting the engaging portion,
the frame-side main plate has a through hole, and the support-side main plate has, in the longitudinal direction, an end surface where a screw hole is formed, and
the engaging portion fits the cut out portion, and a screw member is inserted into the through hole and threadably mounted on the screw hole so as to secure the supporting member to the framing member.

2. The solar cell module according to claim 1, wherein
the engaging portion has a portion with a narrow width, the portion being formed by forming a notch at least at one side in a width direction of the support-side lower plate.

3. The solar cell module according to claim 2 wherein
the engaging portion and the cut out portion are each formed in a T shape in plan view.

4. The solar cell module according to any one of claims 1 to 3, wherein
the through hole is formed in the frame-side main plate between the holding plate portion and the frame-side lower plate in a position closer to the holding plate portion than the frame-side lower plate.

5. The solar cell module according to claim 4, wherein
the frame-side main plate and the end surface of the support-side main plate are secured with a screw in one position.

6. The solar cell module according to any one of claims 1 to 5, wherein
at least a part of a surface that faces the solar cell panel at both end portions in a longitudinal direction of the supporting member is supported by the holding plate portion of the framing member.

7. The solar cell module according to any one of claims 1 to 6, wherein
the supporting member includes a support-side upper plate, the support-side upper plate being disposed to face the support-side lower plate parallel to each other across the support-side main plate.

8. The solar cell module according to claim 7, wherein
both end portions in a longitudinal direction of the support-side upper plate are supported by the holding plate portion of the framing member.

9. A method for manufacturing the solar cell module according to any one of claims 1 to 8, comprising:
holding the edge portion of the solar cell panel in the holding plate portion of the framing member so as to hold the peripheral edge portion of the solar cell panel with the framing member;
fitting the engaging portion to the cut out portion, the engaging portion being formed in the support-side lower plate of the supporting member, the cut out portion being formed in the frame-side lower plate of the framing member;
inserting the screw member into the through hole and threadably mounting the screw member in the screw hole so as to secure the supporting member to the framing member.
